## Europäisches Patentamt

## European Patent Office

## Office européen des brevets

(11) Veröffentlichungsnummer: **0 191 291**
**B1**

(12) **EUROPÄISCHE PATENTSCHRIFT**

(45) Veröffentlichungstag der Patentschrift:
05.04.89

(51) Int. Cl.⁴: **H01M 2/10**, H01R 23/72, H01R 4/48, H05K 7/10, H01M 2/20

(21) Anmeldenummer: 86100171.7

(22) Anmeldetag: 08.01.86

(54) Batteriehalter für Flachbaugruppen.

(30) Priorität: 11.02.85 DE 8503703 U

(43) Veröffentlichungstag der Anmeldung:
20.08.86 Patentblatt 86/34

(45) Bekanntmachung des Hinweises auf die Patenterteilung:
05.04.89 Patentblatt 89/14

(84) Benannte Vertragsstaaten:
AT BE DE FR GB IT NL SE

(56) Entgegenhaltungen:
DE-B- 2 335 063
GB-A- 2 073 963
US-A- 2 692 944
US-A- 2 983 778
US-A- 3 059 153
US-A- 4 252 390

IBM TECHNICAL DISCLOSURE BULLETIN, Band 23, Nr. 10, März 1981, Seiten 4474-4475, New York, US; F.H. SARNACKI: "Receptacle attachment"

(73) Patentinhaber: **Siemens Aktiengesellschaft Berlin und München, Wittelsbacherplatz 2, D-8000 München 2(DE)**

(72) Erfinder: **Foissner, Herbert, Dipl.-Ing. (FH), Gipsenweg 16, D-8190 Wolfratshausen(DE)**

ACTORUM AG

## Beschreibung

Die Erfindung bezieht sich auf einen Batteriehalter für Flachbaugruppen für eine Batterie oder für einen aufladbaren Akku mit zwei in einer Leiterplatte eingesetzten und verlöteten Kontaktelementen.

Elektronische Schalteinrichtungen oder Datenverarbeitungsanlagen weisen eine Vielzahl von Flachbaugruppen auf. Die Flachbaugruppen sind sehr häufig mit Halbleiterspeichern bestückt, u.a. mit sogenannten RAM. Zur Erhaltung der in einem RAM gespeicherten Daten bei fehlender Gesamtstromversorgung, wie sie beispielsweise bei Stromausfall oder bei gezogener Flachbaugruppe der Fall ist, muß eine Stromquelle für die Speisung der RAM-Bausteine vorgesehen sein. Damit die Batterien oder Akkus bei langen Lagerzeiten der Flachbaugruppen nicht schon entleert oder sogar bei Burn-In-Tests frühzeitig beschädigt werden, wurden bisher die Batterien in die Flachbaugruppen sehr häufig erst zum geeigneten Zeitpunkt von Hand eingelötet. Dies ist jedoch umständlich und oft recht lästig. Außerdem läßt sich dann nicht ohne weiteres eine verbrauchte Batterie oder ein untauglich gewordener Akku austauschen.

Aufgabe der Erfindung ist es daher, einen Batteriehalter für Flachbaugruppen zu schaffen, der ein einfaches Einsetzen und Austauschen der Batterie von Hand ermöglicht. Dabei soll der Austausch auch bei gesteckter Flachbaugruppe möglich sein, damit das RAM dabei von der Gesamtstromversorgung versorgt werden kann. Diese Aufgabe wird erfindungsgemäß mit den kennzeichnenden Merkmalen des Anspruchs 1 gelöst.

Der Batteriehalter ist vorzugsweise für zylindrische oder ovale Batterien zu verwenden. Er besteht aus den beiden Kontaktelementen, die in vorteilhafter Weise direkt in die Leiterplatte eingesetzt und beim Maschinenlöten der übrigen Bauteile mitgelötet werden. Das erste Kontaktelement ist im wesentlichen aus einem rechtwinklig geformten Blechstück gebildet, das eine parallel zur Leiterplatte angeordnete Auflagefläche und eine senkrecht dazu angeformte Kontaktfläche aufweist. Die Kontaktfläche weist zumindest einen Kontaktpunkt und an den beiden Außenseiten je einen angeformten Lötkontakt auf, der durch die Leiterplatte gesteckt und dort verlötet ist. Die flache Auflagefläche reicht bis in die Nähe des zweiten Kontaktelementes und besitzt dort einen weiteren Lötkontakt, der ebenfalls durch die Leiterplatte gesteckt und verlötet ist. Dadurch wird in vorteilhafter Weise eine hohe Stabilität und Kippsicherheit erreicht. Auf der Batterieseite, also zum zweiten Kontaktelement hinweisend, ist auf der Kontaktfläche zumindest ein Kontaktpunkt, beispielsweise in Form einer Warze, angebracht. Das zweite Kontaktelement ist aus einem mehrfach abgewinkelten Blechstück gebildet, das zwei senkrecht zur Leiterplatte angeordnete flächige Schenkel aufweist. Diese sind mit einem im rechten Winkel dazu angeformten Joch verbunden. Ferner ist an einem Schenkel rechtwinklig eine Stützfläche angeformt, die zumindest im Bereich der Leiterplatte bis in die Nähe des ersten Kontaktelements reicht und dort einen angeformten Lötkontakt aufweist, der durch die Leiterplatte gesteckt und verlötet ist. An jedem Schenkel ist ebenfalls ein durch die Leiterplatte gesteckter Lötkontakt angeformt.

Ferner ist am Joch nahezu rechtwinklig zwischen den beiden Schenkeln ein federnder Lappen angeformt, der eine Blattfeder bildet und einen Kontaktpunkt aufweist. Die Kontaktierung der Batterie erfolgt an zwei Anlagestellen. Beispielsweise liegt der Pluspol an der Warze der Kontaktfläche des ersten Kontaktelements, der Minuspol an der federnden Kontaktstelle des angeformten, federnden Lappens. Die dadurch erreichte Kontaktkraft ist mit beispielsweise 12 N relativ groß gewählt, um die Oxydschichten oder Verunreinigungen der Metallflächen zu durchstoßen. Die drei Lötanschlüsse des zweiten Kontaktelements gewähren ebenfalls eine hohe Stabilität und Kippsicherheit. Mit der neuerungsgemäßen Ausbildung der beiden Kontaktelemente wird erreicht, daß die Reaktionskräfte nicht unmittelbar auf die Lötpunkte wirken. Dazu kann in vorteilhafter Weise der durch die Leiterplatte gesteckte dritte Lötkontakt des ersten Kontaktelements zusätzlich abgewinkelt sein.

Weitere Ausgestaltungen und Vorteile der Erfindung ergeben sich aus den Unteransprüchen.

Anhand der Zeichnung wird die Erfindung näher erläutert. Dabei zeigt

Fig. 1 einen erfindungsgemäßen Batteriehalter in perspektivischer Darstellung und
Fig. 2 eine Seitenansicht des Batteriehalters.

Auf der Leiterplatte 2 einer Flachbaugruppe ist der Batteriehalter in unmittelbarer Nähe der Leiterplattenvorderkante 2a angeordnet. Das hat den Vorteil, daß die Batterie 1 auch bei gesteckter Flachbaugruppe ausgewechselt werden kann. Der Batteriehalter besteht aus zwei Kontaktelementen 3 und 4. Das erste Kontaktelement 3 ist mit seiner senkrecht zur Leiterplatte 2 angeordneten Kontaktfläche 3b mit Hilfe der beiden an den Außenkanten angeformten Lötkontakten 3d in der Leiterplatte 2 eingesteckt und dort verlötet. Die an der Kontaktfläche 3b angeformte Auflagefläche 3a verläuft parallel zur Leiterplatte 2 und weist an ihrer Vorderkante, in der Nähe des zweiten Kontaktelements 4, einen angeformten Lötkontakt 3e auf, der durch die Leiterplatte gesteckt und auf der gegenüberliegenden Seite abgewinkelt und dort verlötet ist. Die Kontaktfläche 3b des ersten Kontaktelements 3 weist in diesem Ausführungsbeispiel zwei warzenförmige Kontaktpunkte 3c auf, die eine sichere Kontaktgabe mit der Batterie 1 gewährleisten. Das zweite Kontaktelement 4 ist entsprechend der Größe der Batterie 1 gegenüber dem ersten Kontaktelement 3 angeordnet. Das Kontaktelement 4 weist zwei senkrecht zur Leiterplatte 2 angeordnete Schenkel 4a auf, die an der Leiterplatte 2 je einen angeformten Lötkontakt 4f besitzen, der durch die Leiterplatte 2 gesteckt und verlötet ist. Er kann auf der gegenüberliegenden Seite auch abgewinkelt sein. Mit dem im rechten Winkel zu einem Schenkel 4a des Kontaktelements 4 angeformten Stützblech 4c wird ein dritter Auflage- und Lötanschlußpunkt erzielt. Das Stützblech 4c ist stufenförmig ausgebildet und reicht im Bereich der Leiterplatte 2 sehr nahe an das Kontaktelement 3 heran. Dort ist der Lötkontakt 4g angeformt, der durch die Leiterplatte 2 gesteckt und dort verlötet ist. Auch dieser Lötanschluß 4g kann auf der anderen Seite der Leiterplatte 2 abgewinkelt werden. Zur Erhöhung der Stabilität ist bei diesem Ausführungsbeispiel in der Nähe des Schenkels 4a an der Stützfläche 4c ein zusätzlicher Lötanschluß 4h angeformt. Die beiden Schenkel 4a sind mit einem im rechten Winkel zu den Schenkeln 4a angeordneten Joch 4b verbunden. An das Joch 4b ist zwischen den beiden Schenkeln 4a im rechten Winkel ein Lappen 4e angeformt, der wie eine Blattfeder wirkt und an seinem freien Ende einen Kontaktpunkt 4e besitzt. Dieser Kontaktpunkt ist in Form eines spitz zulaufenden Lappens ausgebildet, der senkrecht zur Blattfeder angeformt ist und zur Batterie hinweist.

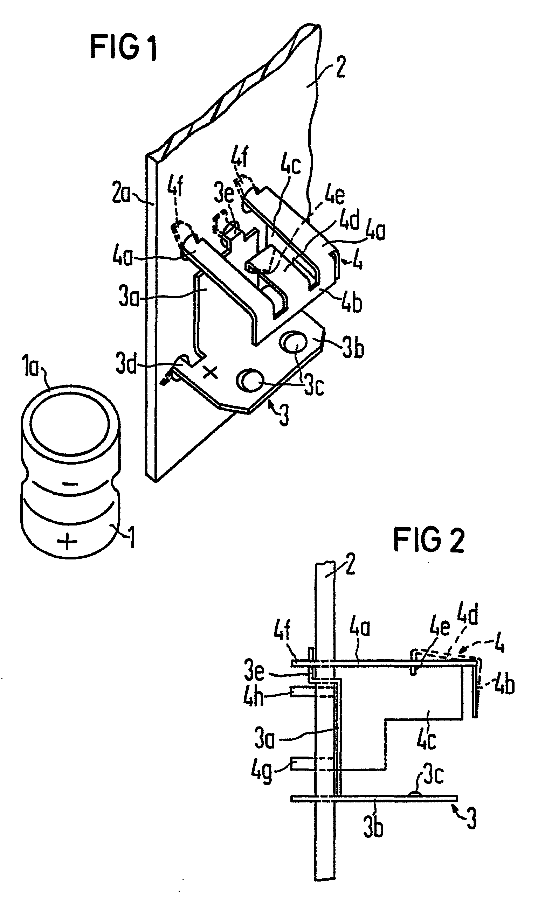

Die Anordnung und Ausbildung der beiden Kontaktelemente 3 und 4 ist so gewählt, daß insbesondere bei eingestecktem Nickel-Cadmium-Akkus 1 eine Lage des Akkus erreicht wird, die die gefalzte Dichtungsstelle 1a nach oben zeigen läßt. Dadurch wird bei undichten Akkus das Auslaufen verhindert, so daß keine Beschädigung der Flachbaugruppe auftreten kann. Um die relativ hohen Toleranzen der Batteriehöhen von beispielsweise 1,5 mm ausgleichen zu können, ist ein möglichst großer Federweg des Kontaktpunkts 4e mit der erfindungsgemäßen Batteriehalterung bezweckt worden. Dies wurde dadurch erreicht, daß die Blattfeder 4e im Bereich des Jochs 4b zwischen den beiden Schenkeln 4a hineinragt. Schon bei einer kleinen Bewegung des Jochs 4b wird die Blattfeder 4d im Verhältnis c zu b ausgelenkt. Zusätzlich wird dabei der Federweg der Blattfeder 4d ausgenützt. Dies ist in der Fig. 2 gestrichelt angedeutet.

## Patentansprüche

1. Batteriehalter für Flachbaugruppen für eine Batterie (1) mit zwei in einer Leiterplatte (2) eingesetzten und verlöteten Kontaktelementen (3 und 4), gekennzeichnet durch die Kombination folgender Merkmale:
   a) das erste Kontaktelement (3) ist im wesentlichen aus einem rechtwinklig geformten Blechstück mit einer parallel zur Leiterplatte (2) angeordneten Auflagefläche (3a) und einer senkrecht dazu angeordneten Kontaktfläche (3b) gebildet,
   b) die Kontaktfläche (3b) weist zumindest einen Kontaktpunkt (3c) und an den beiden Außenseiten je einen angeformten, durch die Leiterplatte (2) gesteckten Lötkontakt (3d) auf,
   c) die Auflagefläche (3a) reicht bis in die Nähe des zweiten Kontaktelements (4) und weist einen weiteren Lötkontakt (3e) auf, der an der Außenkante, die dem zweiten Kontaktelement (4) zugewandt ist, angeformt ist,
   d) das zweite Kontaktelement (4) ist aus einem mehrfach abgewinkelten Blechstück mit zwei senkrecht zur Leiterplatte (2) angeordneten, flächigen Schenkeln (4a), die mit einem im rechten Winkel dazu angeformten Joch (4b) verbunden sind, und mit einer rechtwinklig an einem Schenkel (4a) angeformten Stützfläche (4c) gebildet,
   e) am Joch (4b) ist nahezu rechtwinklig ein als Blattfeder ausgebildeter, zwischen den beiden Schenkeln (4a) federnder Lappen (4d) mit einem Kontaktpunkt (4e) angeformt,
   f) jeder Schenkel (4a) weist einen angeformten, durch die Leiterplatte (2) gesteckten Lötkontakt (4f) auf,
   g) die Stützfläche (4c) reicht zumindest im Bereich der Leiterplatte (2) bis in die Nähe des ersten Kontaktelements (3) und weist dort einen angeformten, durch die Leiterplatte (2) gesteckten Lötkontakt (4g) auf.

2. Batteriehalter nach Anspruch 1, dadurch gekennzeichnet, daß der weitere, durch die Leiterplatte (2) gesteckte Lötkontakt (3e) des ersten Kontaktelements zusätzlich abgewinkelt ist.

3. Batteriehalter nach einem der vorhergehenden Ansprüche, dadurch gekennzeichnet, daß das Joch (4b) des zweiten Kontaktelements (4) parallel zur Leiterplatte (2) angeordnet ist und einen Abstand zur Leiterplatte (2) aufweist, der der Dicke der Batterie (1) entspricht.

4. Batteriehalter nach einem der vorhergehenden Ansprüche, dadurch gekennzeichnet, daß die Schenkel (4a) des zweiten Kontaktelements (4) parallel zur Kontaktfläche (3b) angeordnet sind.

5. Batteriehalter nach einem der vorhergehenden Ansprüche, dadurch gekennzeichnet, daß die Stützfläche (4c) in der Nähe des Schenkels (4a) einen zusätzlichen Lötkontakt (4h) aufweist.

6. Batteriehalter nach einem der vorhergehenden Ansprüche, dadurch gekennzeichnet, daß der Kontaktpunkt (4e) der Blattfeder (4d) von einer dornförmigen Anformung gebildet ist.

7. Batteriehalter nach einem der vorhergehenden Ansprüche, dadurch gekennzeichnet, daß die Kontaktfläche (3b) des ersten Kontaktelements (3) zwei zum zweiten Kontaktelement (4) weisende Kontaktpunkte (3c) aufweist, die als Warzen ausgebildet sind.

## Claims

1. Battery holder for flat assembly modules for a battery (1), having two contact elements (3 and 4) installed and soldered in a circuit board (2), characterised by the combination of the following features:
   a) the first contact element (3) is made essentially from a rectangularly formed piece of sheet metal having a bearing surface (3a) arranged parallel to the circuit board (2) and a contact surface (3b) arranged perpendicularly thereto,
   b) the contact surface (3b) has at least one contact point (3c) and, at each of the two outer sides, an integrally formed solder contact (3d) inserted through the circuit board (2),
   c) the bearing surface (3a) reaches as far as the vicinity of the second contact element (4), and has a further solder contact (3e), which is integrally formed on the outer edge, which faces the second contact element (4),
   d) the second contact element (4) is made from a multiply bent piece of sheet metal having two plane legs (4a), which are arranged perpendicularly to the circuit board (2) and are connected by a yoke (4b) integrally formed at a rightangle thereto, and having a supporting surface (4c) integrally formed rectangularly at one leg (4a),

e) there is integrally formed almost rectangularly at the yoke (4b) a tongue (4d) having a contact point (4e), which tongue is constructed as a leaf spring and moves resiliently between the two legs (4a),

f) each leg (4a) has an integrally formed solder contact (4f), which is inserted through the circuit board (2),

g) at least in the region of the circuit board (2), the supporting surface (4c) reaches as far as the vicinity of the first contact element (3), and has there an integrally formed solder contact (4g), which is inserted through the circuit board (2).

2. Battery holder according to Claim 1, characterised in that the further solder contact (3e) of the first contact element, which solder contact is inserted through the circuit board (2), is additionally bent.

3. Battery holder according to one of the preceding Claims, characterised in that the yoke (4b) of the second contact element (4) is arranged parallel to the circuit board (2), and has a separation from the circuit board (2) which corresponds to the thickness of the battery (1).

4. Battery holder according to one of the preceding Claims, characterised in that the legs (4a) of the second contact element (4) are arranged parallel to the contact surface (3b).

5. Battery holder according to one of the preceding Claims, characterised in that the supporting surface (4c) has an additional solder contact (4h) in the vicinity of the leg (4a).

6. Battery holder according to one of the preceding Claims, characterised in that the contact point (4e) of the leaf spring (4d) is made from an integral thorn-shaped formation.

7. Battery holder according to one of the preceding Claims, characterised in that the contact surface (3b) of the first contact element (3) has two contact points (3c) facing the second contact element (4), which are constructed as bosses.

## Revendications

1. Support de pile pour des modules plats, destiné à supporter une pile (1) comportant deux éléments de contact (3 et 4) insérés et brasés dans une plaquette à circuits imprimés (2), caractérisé par la combinaison de caractéristiques suivantes:

a) le premier élément de contact (3) est formé essentiellement par un élément de tôle de forme rectangulaire possédant une surface d'appui (3a) parallèle à la plaquette à circuits imprimés (2), et une surface de contact (3b) perpendiculaire à cette surface d'appui,

b) la surface de contact (3b) comporte au moins un point de contact (3c) et, sur les deux faces extérieures, des contacts respectifs à braser (3d) formés par façonnage et enfichés à travers la plaquette à circuits imprimés (2),

c) la surface d'appui (3a) s'étend jusqu'au voisinage du second élément de contact (4) et possède un autre contact à braser (3a), qui est formé par façonnage sur l'arête extérieure, tournée vers le second élément de contact (4),

d) le second élément de contact (4) est formé par un élément de tôle replié de façons multiples et comportant deux branches (4a) possédant une certaine étendue, perpendiculaires à la plaquette à circuits imprimés (2) et reliées à une barrette (4b) formée par façonnage perpendiculairement aux branches, et possédant une surface de support (4c) formée par façonnage, dans une position perpendiculaire, sur une branche (4a),

e) une languette (4d) réalisée sous la forme d'un ressort à lame, située entre les deux branches (4a) et possédant un point de contact (4a) et formée par façonnage, dans une position presque perpendiculaire, sur la barrette (4b),

f) chaque branche (4a) possède un contact à braser (4f) formé par façonnage sur cette branche et enfiché à travers la plaquette à circuits imprimés (2),

g) la surface du support (4c) s'étend au moins au voisinage de la plaquette à circuits imprimés (2), jusqu'à proximité du premier élément de contact (3) et possède, en cet endroit, un contact à braser (4g) formé par façonnage sur cette surface de support et enfiché à travers la plaquette à circuits imprimés (2).

2. Support de pile selon la revendication 1, caractérisé par le fait que l'autre contact à braser (3a), enfiché à travers la plaquette à circuits imprimés (2), du premier élément de contact est en outre coudé.

3. Support de pile suivant l'une des revendications précédentes, caractérisé par le fait que la barrette (4b) du second élément de contact (4) est parallèle à la plaquette à circuits imprimés (2) et est séparée de cette dernière par une distance correspondant à épaisseur de la pile (1).

4. Support de pile suivant l'une des revendications précédentes, caractérisé par le fait que les branches (4a) du second élément de contact (4) sont parallèles à la surface de contact (3b).

5. Support de pile suivant l'une des revendications précédentes, caractérisé par le fait que la surface du support (4c) comporte, à proximité de la branche (4a), un contact à braser supplémentaire (4h).

6. Support de pile suivant l'une des revendications précédentes, caractérisé par le fait que le point de contact (4a) du ressort à lame (4d) est formé par façonnage avec une forme pointue.

7. Support de pile suivant l'une des revendications précédentes, caractérisé par le fait que la surface de contact (3b) du premier élément de contact (3) comporte deux points de contact (3c) dirigés vers le second élément de contact (4) et est réalisée sous la forme de boutons.

FIG 1

FIG 2